(19) **Europäisches Patentamt / European Patent Office / Office européen des brevets**

(11) **EP 4 344 063 B1**

(12) **FASCICULE DE BREVET EUROPEEN**

(45) Date de publication et mention de la délivrance du brevet:
**21.01.2026 Bulletin 2026/04**

(21) Numéro de dépôt: **23196492.5**

(22) Date de dépôt: **11.09.2023**

(51) Classification Internationale des Brevets (IPC):
**H03K 5/1534** (2006.01)   **H03M 1/06** (2006.01)
**H04L 7/00** (2006.01)   **G06F 1/12** (2006.01)

(52) Classification Coopérative des Brevets (CPC):
**H04L 7/0012; G06F 1/12;** H03K 5/1534;
H03M 1/0624; H03M 1/12; H03M 1/66

(54) **PROCÉDÉ DE DÉTERMINATION DU DÉPHASAGE ENTRE UN PREMIER SIGNAL D'HORLOGE REÇU PAR UN PREMIER COMPOSANT ÉLECTRONIQUE ET UN DEUXIÈME SIGNAL D'HORLOGE REÇU PAR UN DEUXIÈME COMPOSANT ÉLECTRONIQUE**

VERFAHREN ZUR BESTIMMUNG DER PHASENVERSCHIEBUNG ZWISCHEN EINEM ERSTEN, EINEM ERSTEN ELEKTRONISCHEN BAUELEMENT EMPFANGENEN TAKTSIGNAL UND EINEM ZWEITEN, ELEKTRONISCHEN TAKTSIGNAL

METHOD FOR DETERMINING THE PHASE SHIFT BETWEEN A FIRST CLOCK SIGNAL RECEIVED BY A FIRST ELECTRONIC COMPONENT AND A SECOND CLOCK SIGNAL RECEIVED BY A SECOND ELECTRONIC COMPONENT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **22.09.2022 FR 2209612**

(43) Date de publication de la demande:
**27.03.2024 Bulletin 2024/13**

(73) Titulaire: **Teledyne E2V Semiconductors SAS**
**38120 Saint-Egrève (FR)**

(72) Inventeurs:
• **JORET, Simon**
**38120 SAINT EGREVE (FR)**
• **BERAUD-SUDREAU, Quentin**
**38120 SAINT EGREVE (FR)**
• **LAUBE, Rémi**
**38120 SAINT EGREVE (FR)**
• **BREYSSE, Stéphane**
**38120 SAINT EGREVE (FR)**

• **MARTIN, Matthieu**
**38120 SAINT EGREVE (FR)**
• **COCHARD, Julien**
**38120 SAINT EGREVE (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
WO-A1-2021/032767   US-B1- 10 509 104

• STACKLER MARC ET AL: "A novel method to synchronize high-speed data converters", 2016 IEEE RADAR CONFERENCE (RADARCONF), IEEE, 2 May 2016 (2016-05-02), pages 1 - 5, XP032909076, DOI: 10.1109/ RADAR.2016.7485292

**EP 4 344 063 B1**

## Description

## Domaine technique

L'invention se rapporte à un procédé de détermination du déphasage entre un premier signal d'horloge reçu par un premier composant électronique et un deuxième signal d'horloge reçu par un deuxième composant électronique, ainsi qu'à un système de détermination du déphasage entre un premier signal d'horloge reçu par un premier composant électronique et un deuxième signal d'horloge reçu par un deuxième composant électronique.

Les contraintes de distribution d'horloge dans un système électronique augmentent avec la fréquence d'horloge. Il est parfois nécessaire de contrôler l'alignement des horloges entre différents composants de même type pour les faire travailler ensemble, par exemple plusieurs convertisseurs analogiques/numériques dans un réseau d'antennes ou dans un radar à antenne active. Ces alignements d'horloges requièrent parfois des précisions inférieures au degré. Par exemple, pour une horloge à 12 GHz, un degré de déphasage correspond à environ 200 fs. Ces faibles déphasages requis sont directement impactés par le routage, les variations de procédés lors de la fabrication des PCB, ou encore les composants. Cela rend l'alignement des horloges difficile.

Dans une configuration à plusieurs composants électroniques, un ou des générateurs d'horloge transmettent un signal d'horloge sur différents chemins d'horloge. Du fait des dispersions mentionnées précédemment, le signal d'horloge peut subir un déphasage d'un composant à l'autre, ce qui peut compromettre la synchronisation des composants électroniques.

Pour atteindre un alignement de l'ordre de la centaine de femto-secondes, le déphasage entre chaque composant doit être mesuré, pour ensuite être corrigé soit par post traitement, soit en apportant du délai sur les chemins d'horloge, soit à l'aide de solutions embarquées dans les composants.

Le document D1 (WO 2021/032767 A1 décrit un procédé de synchronisation de données analogiques en sortie d'une pluralité de convertisseurs numérique/analogique.

Le document D2 (US 10 509 104 B1) décrit un procédé de synchronisation de puces radars.

Pour réaliser la mesure du déphasage, une solution connue consiste à étalonner le système final après fabrication. Un signal prédéterminé est injecté en entrée des différents composants, et les déphasages entre les canaux sont comparés en post traitement.

Cette solution présente les inconvénients suivants :

- pour chaque système, il est nécessaire de procéder à une caractérisation du déphasage sur toute la plage de fonctionnement (température, niveau des tensions d'alimentation, fréquence de travail). Cela nécessite des moyens d'essais complexes et coûteux

- il y a lieu de contrôler la valeur de ces paramètres en temps réel, pour appliquer la bonne correction, avec pour conséquence une complexité supplémentaire significative, surtout lorsque le nombre de canaux est conséquent

- l'étalonnage risque d'évoluer avec le temps en raison du vieillissement des composants. Il faut donc le mettre régulièrement à jour.

Certains systèmes intègrent des voies d'étalonnage pour actualiser la mesure des déphasages en temps réel. L'avantage principal de cette solution est de supprimer la phase de caractérisation en usine sur toute la plage de fonctionnement. Le déphasage est mesuré en temps réel, et la correction correspondante est appliquée. La correction tient compte du vieillissement des composants.

Toutefois, les solutions connues de mesure du déphasage en temps réel présentent les inconvénients suivants :

- il faut prévoir des canaux spécifiques pour l'étalonnage, ce qui augmente la taille, la consommation, le coût et la complexité du système. De plus, des commutateurs sont nécessaires pour basculer entre le mode calibration et le mode de fonctionnement normal. Ces commutateurs peuvent dégrader les performances RF, en générant des signaux parasites à haute fréquence.

- le mode calibration et le mode fonctionnement normal sont exclusifs. Il y a donc une perte de service pendant l'étalonnage.

- la mesure du déphasage consiste à faire des corrélations entre les différents canaux. Ces corrélations sont lourdes en terme de puissance de calcul, d'autant plus lorsque le nombre de canaux est élevé. Comme ces calculs sont embarqués dans le système, les ressources utilisées pour l'étalonnage ne sont pas disponibles pour d'autres tâches.

Il existe donc un besoin pour un procédé de détermination en temps réel du déphasage des signaux d'horloge distribués à des composants électroniques, qui n'occasionne pas de perte de service pendant l'étalonnage.

**Résumé de l'invention**

Un objet de l'invention est donc un procédé de détermination du déphasage entre un premier signal d'horloge reçu par un premier composant électronique et un deuxième signal d'horloge reçu par un deuxième composant électronique, le premier signal d'horloge et le deuxième signal d'horloge étant générés de façon synchrone et ayant une période d'horloge identique, comprenant les étapes consistant à :

S10) émission d'un premier signal d'étalonnage par le premier composant électronique de manière synchrone avec le premier signal d'horloge ;

S20) mesure d'un premier délai entre un front actif du premier signal d'étalonnage et un front actif du deuxième signal d'horloge consécutif au front actif du premier signal d'étalonnage ;

S30) émission d'un deuxième signal d'étalonnage par le deuxième composant électronique de manière synchrone avec le deuxième signal d'horloge ;

S40) mesure d'un deuxième délai entre un front actif du deuxième signal d'étalonnage et un front actif du premier signal d'horloge consécutif au front actif du deuxième signal d'étalonnage ;

S50) mesure du nombre de coups d'horloge entre l'émission du premier signal d'étalonnage et le front actif du premier signal d'horloge consécutif au front actif du deuxième signal d'étalonnage, le nombre de coups d'horloge correspondant à un multiple de la période d'horloge ;

S60) détermination du déphasage en fonction de la parité du nombre de coups d'horloge.

Avantageusement,

$$T_\phi = \frac{T_1 - T_2}{2} - \frac{T_c}{2}$$

si n est impair

$$T_\phi = \frac{T_1 - T_2}{2}$$

si n est pair

Où n correspond au nombre de coups d'horloge, $T_\phi$ correspond au déphasage entre le premier signal d'horloge et le deuxième signal d'horloge, $T_1$ correspond au premier délai, $T_2$ correspond au deuxième délai, et $T_c$ correspond à la période d'horloge.

Avantageusement, le deuxième signal d'étalonnage est émis après un nombre prédéterminé de coups d'horloge consécutifs au premier délai.

Avantageusement, le procédé comprend en outre une étape de correction du déphasage entre le premier composant électronique et le deuxième composant électronique, en fonction du déphasage déterminé à l'étape S60).

Avantageusement, la détermination du déphasage est effectuée de façon périodique.

Avantageusement le premier signal d'étalonnage est routé sur une première ligne, le deuxième signal d'étalonnage est routé sur une deuxième ligne, la longueur de la première ligne et la longueur de la deuxième ligne étant égales.

En variante, le premier signal d'étalonnage et le deuxième signal d'étalonnage sont routés sur une seule et même ligne bidirectionnelle, le deuxième signal d'étalonnage étant retardé par rapport à la réception du premier signal d'étalonnage de façon à éviter un conflit entre le premier signal d'étalonnage et le deuxième signal d'étalonnage.

L'invention se rapporte aussi à un système de détermination du déphasage entre un premier signal d'horloge reçu par un premier composant électronique et un deuxième signal d'horloge reçu par un deuxième composant électronique, le premier signal d'horloge et le deuxième signal d'horloge étant générés de façon synchrone et ayant une période d'horloge identique, le système étant configuré pour :

- émettre un premier signal d'étalonnage par le premier composant électronique de manière synchrone avec le premier signal d'horloge ;

- mesurer un premier délai entre un front actif du premier signal d'étalonnage et un front actif du deuxième signal d'horloge consécutif au front actif du premier signal d'étalonnage ;

- émettre un deuxième signal d'étalonnage par le deuxième composant électronique de manière synchrone avec le deuxième signal d'horloge ;

- mesurer un deuxième délai entre un front actif du deuxième signal d'étalonnage et un front actif du premier signal d'horloge consécutif au front actif du deuxième signal d'étalonnage ;

- mesurer un nombre de coups d'horloge entre le premier délai et le deuxième délai, le nombre de coups d'horloge correspondant à un multiple de la période d'horloge ;

- déterminer un déphasage en fonction de la parité du nombre de coups d'horloge.

Avantageusement :

$$T_\phi = \frac{T_1 - T_2}{2} - \frac{T_c}{2}$$

si n est impair

$$T_\phi = \frac{T_1 - T_2}{2}$$

si n est pair

Où n correspond au nombre de coups d'horloge, $T_\phi$ correspond au déphasage entre le premier signal d'horloge et le deuxième signal d'horloge, $T_1$ correspond au premier délai, $T_2$ correspond au deuxième délai, et $T_c$ correspond à la période d'horloge.

Avantageusement, le premier composant électronique et le deuxième composant électronique sont des convertisseurs analogiques/numériques ou des convertisseurs numériques/analogiques.

L'invention se rapporte aussi à un système d'antennes en réseau qui comprend au moins le système de détermination du déphasage précité.

**Description des figures**

D'autres caractéristiques, détails et avantages de l'invention ressortiront à la lecture de la description faite en référence aux dessins annexés donnés à titre d'exemple.

La figure 1 illustre un système selon l'invention.

La figure 2 illustre les différentes étapes du procédé selon l'invention.

La figure 3 illustre le principe de mesure du déphasage selon l'invention.

Les figures 4 à 9 illustrent des chronogrammes pour les différents cas de figure en fonction des valeurs $\phi$ et $\delta$.

On appelle « signal d'horloge » un signal électrique oscillant qui rythme les actions d'un circuit. Sa période est appelée cycle d'horloge.

On appelle « canal » (canal de communication ou canal de transmission) un support (physique ou non) permettant la transmission d'une certaine quantité d'information, depuis une source (ou émetteur) vers un destinataire (ou récepteur).

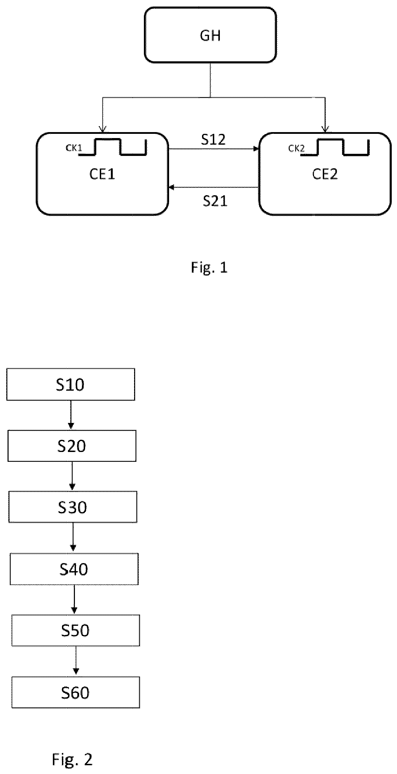

La configuration dans laquelle l'invention est mise en œuvre est illustrée par la figure 1. Un signal d'horloge ayant une période d'horloge $T_c$ est généré par un générateur d'horloge GH. Le générateur d'horloge GH peut être un oscillateur à base de quartz piézoélectrique, ou tout autre composant capable de fournir un signal d'horloge, ayant un cycle d'horloge stable.

Un premier composant électronique CE1 et un deuxième composant électronique CE2 fonctionnent de façon synchrone et utilisent pour cela le signal d'horloge. Selon un mode de réalisation de l'invention, le premier composant électronique CE1 et le deuxième composant électronique CE2 sont des convertisseurs analogiques/numériques, ou des convertisseurs numériques/analogiques d'un réseau d'antennes.

Dans la suite de la description, il est considéré que le premier composant électronique CE1 reçoit un premier signal d'horloge CK1, et que le deuxième composant électronique CE2 reçoit un deuxième signal d'horloge CK2. Le premier signal d'horloge CK1 et le deuxième signal d'horloge CK2 sont générés de façon synchrone : ils sont soit issus du même signal d'horloge fourni par le générateur d'horloge GH, soit ils sont issus de plusieurs générateurs d'horloge qui travaillent de façon synchrone.

En raison de dispersions technologiques entre les composants, de contraintes d'environnement telles que la température, ou de longueurs différentes de câble entre le générateur d'horloge GH et le premier composant électronique CE1 d'une part, et entre le générateur d'horloge GH et le deuxième composant électronique CE2 d'autre part, le signal d'horloge est déphasé au moment où il est reçu par chacun des composants : le front actif (front montant ou front descendant) du signal d'horloge est décalé temporellement d'un composant à l'autre.

Dans la suite de la description, il est considéré que, malgré le déphasage entre les deux signaux d'horloge, le cycle d'horloge (période $T_c$) est identique, et correspond au cycle d'horloge imposé par le générateur d'horloge GH.

Pour mesurer le déphasage, l'invention repose sur un principe de comparaison de la position d'un front du signal de calibration connu par rapport au front de l'horloge, à l'aide d'une ligne de calibration entre composants voisins. Les composants s'envoient mutuellement, sur cette ligne de calibration, un front synchrone avec leur horloge. Il n'est pas nécessaire de prévoir une ligne de calibration centralisée, avec une communication avec une unité de commande centrale, ce qui facilite l'implémentation sur PCB. L'invention utilise en effet un canal existant, qui sert à synchroniser les interfaces numériques des convertisseurs.

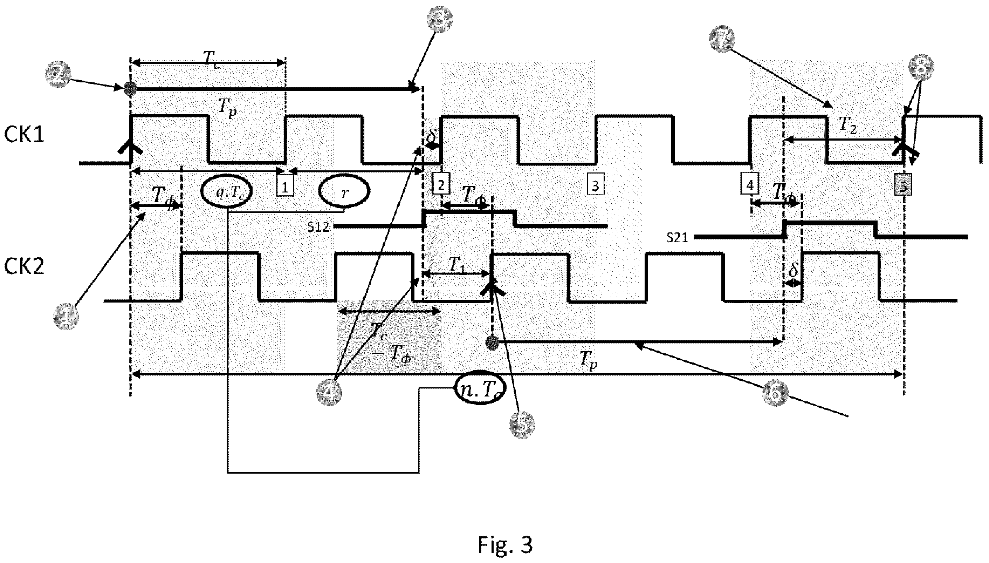

Sur la figure 3, le premier signal d'horloge CK1 et le deuxième signal d'horloge CK2 sont déphasés d'un angle $\phi$ (cf. (1)), ou décalés d'une durée $T_\phi$, les deux étant liés par la relation suivante :

$$\phi = 2\pi . T_\phi . Fc,$$

avec $F_c = 1/T_c$.

Dans une première étape S10 du procédé selon l'invention, un premier signal d'étalonnage S12 est émis par le premier composant électronique CE1 de manière synchrone avec le premier signal d'horloge CK1 (cf. (2) sur la figure 3). Le premier signal d'étalonnage S12 est un signal binaire. Sur la figure 3, le délai de propagation $Tp$ entre l'émission par le premier composant électronique CE1 et sa réception par le deuxième composant électronique CE2 correspond au délai entre le front montant du signal d'horloge CK1 ayant servi à émettre le premier signal d'étalonnage S12 du côté du premier composant électronique CE1 et le front montant du signal d'étalonnage S12 du côté du deuxième composant électronique CE2 (cf. (3) sur la figure 3), mais il pourrait tout aussi bien être décidé de considérer les fronts descendants à la place des fronts montants, sans que cela ne modifie le procédé selon l'invention..

Dans une deuxième étape S20, un premier délai $T_1$ est mesuré entre un front actif du premier signal d'étalonnage S12 et un front actif du deuxième signal d'horloge CK2 consécutif au front actif du premier signal d'étalonnage S12. Le premier délai $T_1$ est séparé du prochain front d'horloge du premier composant électronique CE1 par un délai $\delta$ (cf. (4) sur la figure 3).

Dans une troisième étape S30, un deuxième signal d'étalonnage S21 est émis par le deuxième composant électronique CE2 de manière synchrone avec le deuxième signal d'horloge CK2 (cf. (5) sur la figure 3). Sur la figure 3, l'émission a lieu sur un front montant du deuxième signal d'horloge CK2 ; il s'agit d'une convention, et l'invention pourrait aussi être mise en œuvre en émettant les signaux d'étalonnage sur des fronts descendants.

Le deuxième signal d'étalonnage S21 est un signal binaire. Sur la figure 3, le délai de propagation $T_p$ entre l'émission par le deuxième composant électronique CE2 et sa réception par le premier composant électronique CE1 correspond au délai entre le front montant du côté du premier composant électronique CE1 et le front montant du côté du deuxième composant électronique CE2 (cf. (6) sur la figure 3).

Les lignes sur lesquelles sont transmis le premier signal d'étalonnage S12 et le deuxième signal d'étalonnage S21 ont une longueur identique, afin que les délais de propagation des signaux d'étalonnage soient eux-mêmes identiques. En variante, le premier signal d'étalonnage S12 et le deuxième signal d'étalonnage S21 peuvent être transmis sur une ligne bidirectionnelle. Il faudrait dans ce cas prévoir des buffers bidirectionnels introduisant des retards prédéfinis, de façon à éviter un conflit entre le premier signal d'étalonnage S12 et le deuxième signal d'étalonnage S21.

Le deuxième signal d'étalonnage S21 peut être émis sur le front actif immédiatement consécutif après avoir reçu le premier signal d'étalonnage S12. Toutefois, il est préférable de réémettre le deuxième signal d'étalonnage S21 au bout d'un nombre connu de coup d'horloge. Cela permet de conférer un caractère déterministe à la mesure, et de faire ainsi abstraction de certaines influences extérieures telles que les dispersions technologiques, et les contraintes environnementales.

Dans une quatrième étape S40, un deuxième délai $T_2$ est mesuré entre un front actif du deuxième signal d'étalonnage S21 et un front actif du premier signal d'horloge CK1 consécutif au front actif du deuxième signal d'étalonnage S21. Le deuxième signal d'étalonnage S21 arrive au niveau du premier composant électronique CE1 à un délai $T_2$ avant le prochain front d'horloge du premier signal d'horloge CK1, et à un délai $\delta$ avant le prochain front d'horloge du second signal d'horloge CK2 (cf. (7) sur la figure 3).

Dans une cinquième étape S50, le nombre n de coups d'horloge entre l'émission du premier signal d'étalonnage S12 et le front actif du premier signal d'horloge CK1 consécutif au front actif du deuxième signal d'étalonnage S21 est déterminé. Un coup d'horloge correspond à un cycle d'horloge de période *Tc*. Ce nombre peut être déterminé par une unité de comptage embarquée dans le premier composant électronique CE1. Le deuxième composant électronique CE2 peut aussi comprendre une unité de comptage, ce qui lui permet d'initier la procédure de détermination du déphasage..

Dans une sixième étape S60, le déphasage est déterminé en fonction de la parité du nombre n de coups d'horloge Sur la figure 3, à titre d'exemple, n = 5.

L'émission des signaux de calibration et la détermination de la parité du nombre de coups d'horloge ajoutent très peu de complexité au composant, de sorte qu'il peut facilement être intégré au design du composant. De plus, seulement deux simples lignes PCB entre composants voisins sont nécessaires pour transmettre les signaux de calibration. Dans un mode de réalisation particulièrement avantageux, une seule et unique ligne PCB est nécessaire, dans le cadre d'une liaison bidirectionnelle. La mesure peut être faite en temps réel, de façon parfaitement transparente (sans de perte de service) pour l'utilisateur du système.

La figure 3 a présenté, de façon détaillée, un cas spécifique dans lequel $\Phi < \pi$ (donc $T_\phi < 1/2 . T_C$) et $\delta < T_\phi$.

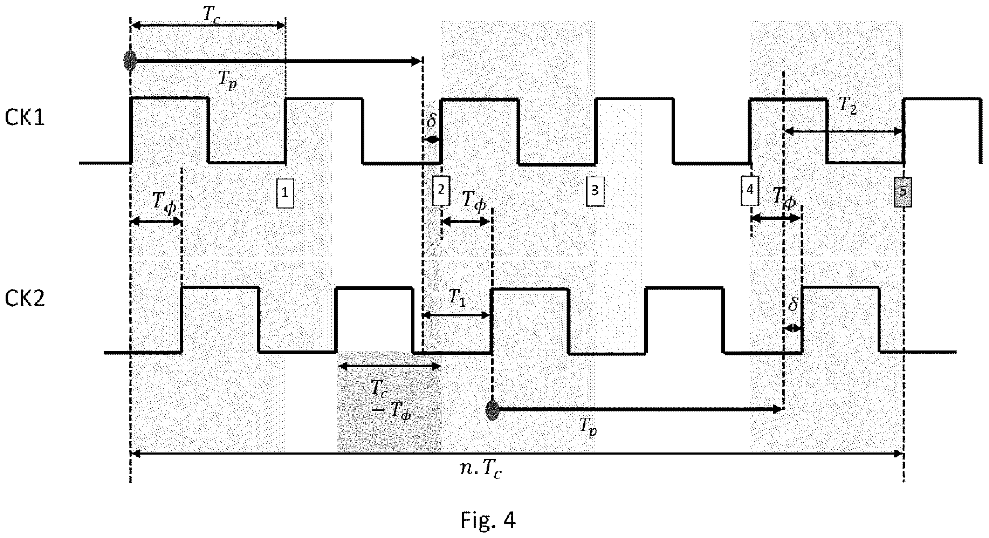

Les figures 4 à 9 illustrent des chronogrammes pour l'ensemble des cas de figures possibles.

Dans tous les cas, à partir des délais définis précédemment, il est possible d'écrire les formules suivantes :

$$n . T_c = 2 . T_p + T_1 + T_2 \text{ (équation générique n°1)}$$

Dans une forme plus générale, un nombre de coups d'horloge peut être ajouté à la formule précédente pour tenir compte d'une temporisation entre la fin du premier délai T1 et l'émission du deuxième signal d'étalonnage S21. Ce nombre étant connu, il ne change rien aux différentes étapes de calcul ci-dessous. Il sera donc considéré, pour simplifier les calculs, que le nombre de coups d'horloge de temporisation est égal à zéro.

: On peut décomposer $T_p$ en la somme d'un nombre entier de coup d'horloge et d'un reste :

$$T_p = q . T_c + r ; q \in \mathbb{N} \text{ (équation générique n°2)}$$

**D'après** la définition de δ, il vient :

$$T_c = r + \delta \text{ (équation générique n°3)}$$

La figure 4 illustre le premier cas de figure, dans lequel $\phi < \pi$ et $\delta < T_\phi$.

Dans ce premier cas, le premier délai $T_1$ et le deuxième délai $T_2$ valent respectivement :

$$T_1 = \delta + T_\phi \text{ (équation spécifique n°1 du cas 1)}$$

$$T_2 = \delta - T_\phi + T_c \text{ (équation spécifique n°2 du cas 1)}$$

Ainsi, on obtient la relation suivante :

$$T_\phi = \frac{T_1 - T_2}{2} - \frac{T_c}{2}$$

En combinant les équations génériques et les équations spécifiques du cas 1, on obtient ainsi :

$$n.T_c = 2.T_p + T_1 + T_2$$

$$n.T_c = 2.(q.T_c + r) + 2.\delta + T_c$$

$$n.T_c = (2q + 3).T_c$$

$$n = 2q + 3$$

Ainsi, pour le cas 1, n est impair.

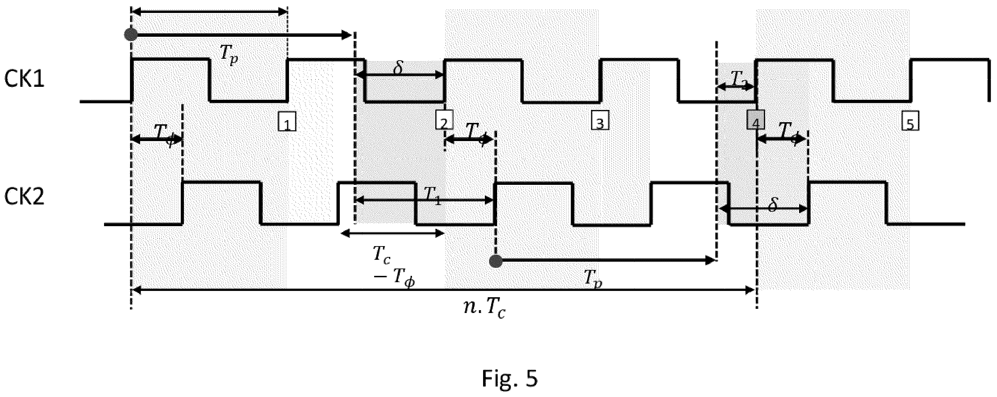

De la même manière, pour le cas 2 illustré par la figure 5, pour lequel $\phi < \pi$ et $T_\phi < \delta < T_c - T_\phi$, le premier délai $T_1$ et le deuxième délai $T_2$ valent respectivement :

$$T_1 = \delta + T_\phi \text{ (équation spécifique n°1 du cas 2)}$$

$$T_2 = \delta - T_\phi \text{ (équation spécifique n°2 du cas 2)}$$

Ainsi, on obtient la relation suivante :

$$T_\phi = \frac{T_1 - T_2}{2}$$

En appliquant les mêmes calculs que précédemment, on obtient :

$$n = 2(q + 1)$$

Ainsi, pour le cas 2, n est pair.

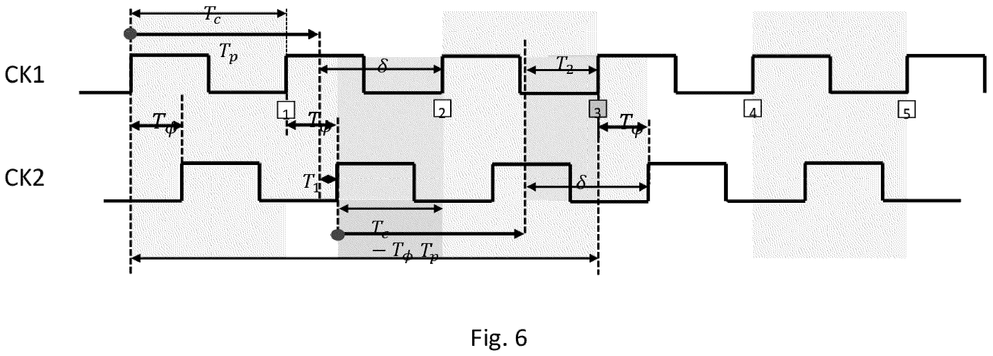

Pour le cas 3 illustré par la figure 6, pour lequel $\phi < \pi$ et $\delta > T_c - T_\phi$, le premier délai $T_1$ et le deuxième délai $T_2$ valent respectivement :

$$T_1 = \delta + T_\phi - T_c \text{ (équation spécifique n°1 du cas 3)}$$

$$T_2 = \delta - T_\phi \text{ (équation spécifique n°2 du cas 3)}$$

Ainsi, on obtient la relation suivante :

$$T_\phi = \frac{T_1 - T_2}{2} - \frac{T_c}{2}$$

En appliquant les mêmes calculs que précédemment, on obtient :

$$|n = 2q + 1$$

Ainsi, pour le cas 3, n est impair.

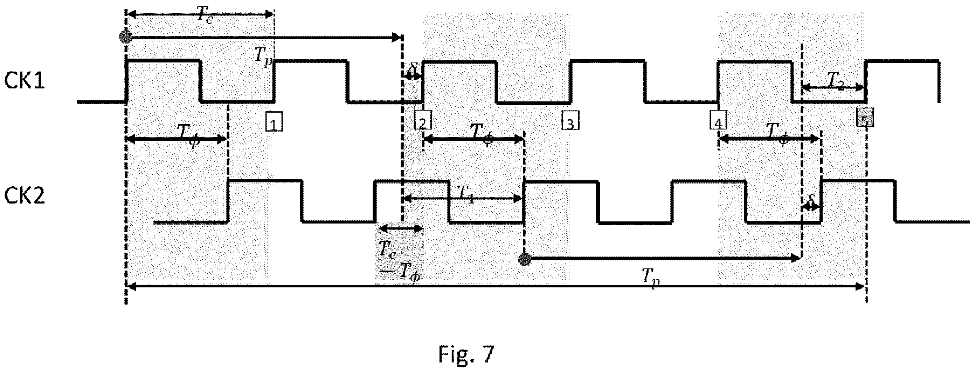

Pour le cas 4 illustré par la figure 7, pour lequel $\phi > \pi$ et $\delta < T_c - T_\phi$, le premier délai $T_1$ et le deuxième délai $T_2$ valent respectivement :

$$T_1 = \delta + T_\phi \text{ (équation spécifique n°1 du cas 4)}$$

$$T_2 = \delta - T_\phi + T_c \text{ (équation spécifique n°2 du cas 4)}$$

Ainsi, on obtient la relation suivante :

$$T_\phi = \frac{T_1 - T_2}{2} - \frac{T_c}{2}$$

En appliquant les mêmes calculs que précédemment, on obtient :

$$n = 2q + 3$$

Ainsi, pour le cas 4, n est impair.

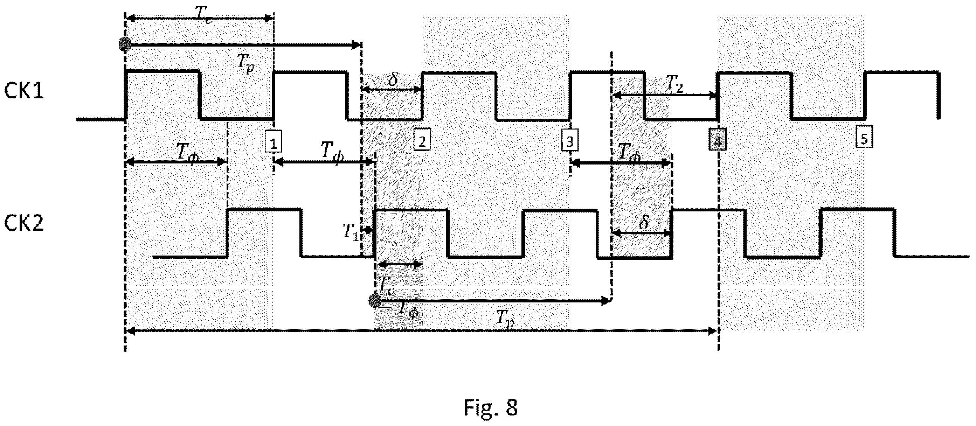

Pour le cas 5 illustré par la figure 8, pour lequel $\phi > \pi$ et $T_c - T_\phi < \delta < T_\phi$, le premier délai $T_1$ et le deuxième délai $T_2$ valent respectivement :

$$T_1 = \delta + T_\phi - T_c \text{ (équation spécifique n°1 du cas 5)}$$

$$T_2 = \delta - T_\phi + T_c \text{ (équation spécifique n°2 du cas 5)}$$

Ainsi, on obtient la relation suivante :

$$T_\phi = \frac{T_1 - T_2}{2}$$

En appliquant les mêmes calculs que précédemment, on obtient :

$$n = 2(q + 1)$$

Ainsi, pour le cas 5, n est pair.

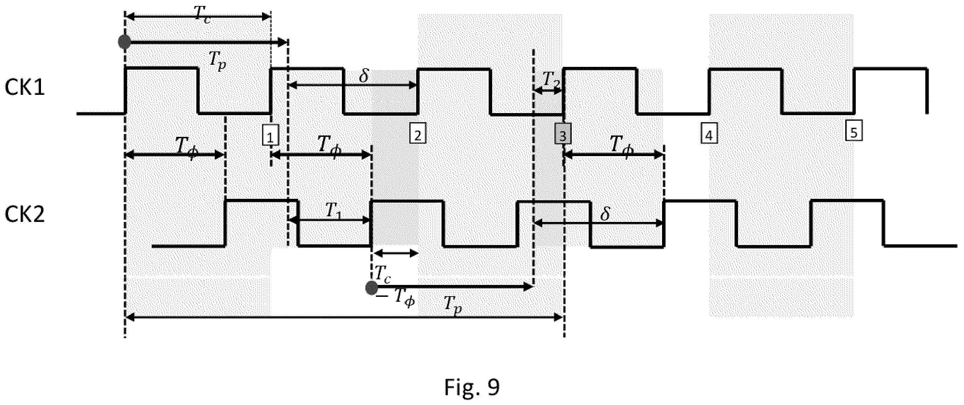

Pour le cas 6 illustré par la figure 9, pour lequel $\phi > \pi$ et $\delta > T_\phi$, le premier délai $T_1$ et le deuxième délai $T_2$ valent respectivement :

$$T_1 = \delta + T_\phi - T_c \text{ (équation spécifique n°1 du cas 6)}$$

$$T_2 = \delta - T_\phi \text{ (équation spécifique n°2 du cas 6)}$$

Ainsi, on obtient la relation suivante :

$$T_\phi = \frac{T_1 - T_2}{2} - \frac{T_c}{2}$$

En appliquant les mêmes calculs que précédemment, on obtient :

$$n = 2q + 1$$

Ainsi, pour le cas 6, n est impair.

Quel que soit le cas de figure, il peut donc être conclu que :

$$T_\phi = \frac{T_1 - T_2}{2} - \frac{T_c}{2}$$

si n est impair

$$T_\phi = \frac{T_1 - T_2}{2}$$

si n est pair

La valeur angulaire $\Phi$ du déphasage entre les signaux d'horloge est reliée à $T_\phi$ par la formule $\Phi = 2\pi. \, T_\phi. \, Fc$, avec $F_c = 1/T_c$.

Le comptage du nombre de coups d'horloge n entre l'émission du premier signal d'étalonnage S12 et le front actif du premier signal d'horloge CK1 consécutif au front actif du deuxième signal d'étalonnage S21 permet ainsi de déterminer la formule à utiliser pour calculer le déphasage entre les deux signaux d'horloge.

Selon un mode de réalisation, le premier délai $T_1$ et le deuxième délai $T_2$ peuvent être déterminés en déterminant le délai utilisé habituellement pour détecter les métastabilités des signaux de synchronisation (signal de synchronisation trop proche d'un front d'horloge) et décrit notamment dans la demande de brevet FR 3 043 477 A1.

Le procédé de détermination du déphasage peut être mis en œuvre de façon périodique. Cela peut être avantageux en particulier dans des environnements avec des fortes variations de température, qui peuvent provoquer des déphasages importants entre les horloges. Dans le cadre d'une utilisation de convertisseurs analogiques/numériques ou de convertisseurs numériques/analogiques dans des antennes mises en réseau dans un satellite, il est essentiel que les alignements de phases soient maitrisées.

Le procédé selon l'invention peut aussi comprendre une étape de correction de la phase d'un des deux signaux d'horloge, en fonction du déphasage déterminé selon le procédé décrit précédemment. La correction peut se faire de façon automatique, en utilisant des solutions de type TDA (Time Delay Adjustment) embarquée dans le composant électronique.

L'invention a été décrite pour déterminer le déphasage entre les signaux d'horloge reçus par deux composants électroniques. S'il y a lieu, le déphasage entre plus de deux signaux d'horloge reçus par plus de deux composants électroniques peut être déterminé, en couplant deux à deux les composants électroniques, et en transmettant les valeurs de déphasage à une unité de commande.

Il peut aussi être avantageux d'appairer deux composants électroniques très éloignés les uns des autres (ce qui peut être le cas pour un réseau d'antennes très étendu), de déterminer le déphasage entre les signaux d'horloge, et d'appliquer la correction correspondante à l'un des deux composants électroniques, ainsi qu'à d'autres composants électroniques disposés à proximité du composant électronique.

Le procédé et le système selon l'invention permettent ainsi de mesurer les erreurs de déphasage sans aucune aide d'un composant extérieur, ce qui facilite son implémentation.

**Revendications**

1. Procédé de détermination du déphasage entre un premier signal d'horloge (CK1) reçu par un premier composant électronique (CE1) et un deuxième signal d'horloge (CK2) reçu par un deuxième composant électronique (CE2), le premier signal d'horloge (CK1) et le deuxième signal d'horloge (CK2) étant générés de façon synchrone et ayant une période d'horloge identique ($T_c$), comprenant les étapes consistant à :

   S10) émission d'un premier signal d'étalonnage (S12) par le premier composant électronique (CE1) de manière synchrone avec le premier signal d'horloge (CK1) ;
   S20) mesure d'un premier délai ($T_1$) entre un front actif du premier signal d'étalonnage (S12) et un front actif du deuxième signal d'horloge (CK2) consécutif au front actif du premier signal d'étalonnage (S12) ;

S30) émission d'un deuxième signal d'étalonnage (S21) par le deuxième composant électronique (CE2) de manière synchrone avec le deuxième signal d'horloge (CK2) ;

S40) mesure d'un deuxième délai ($T_2$) entre un front actif du deuxième signal d'étalonnage (S21) et un front actif du premier signal d'horloge (CK1) consécutif au front actif du deuxième signal d'étalonnage (S21) ;

S50) mesure du nombre (n) de coups d'horloge entre l'émission du premier signal d'étalonnage (S12) et le front actif du premier signal d'horloge (CK1) consécutif au front actif du deuxième signal d'étalonnage (S21), le nombre (n) de coups d'horloge correspondant à un multiple de la période d'horloge ($T_c$) ;

S60) détermination du déphasage en fonction de la parité du nombre (n) de coups d'horloge, du premier délai ($T_1$) et du deuxième délai ($T_2$).

2. Procédé selon la revendication 1, dans lequel :

$$T_\phi = \frac{T_1 - T_2}{2} - \frac{T_c}{2}$$

si n est impair

$$T_\phi = \frac{T_1 - T_2}{2}$$

si n est pair Où *n* correspond au nombre de coups d'horloge, $T_\phi$ correspond au déphasage entre le premier signal d'horloge (CK1) et le deuxième signal d'horloge (CK2), $T_1$ correspond au premier délai, $T_2$ correspond au deuxième délai, et $T_c$ correspond à la période d'horloge.

3. Procédé selon l'une des revendications précédentes, dans lequel le deuxième signal d'étalonnage (S21) est émis après un nombre prédéterminé de coups d'horloge consécutifs au premier délai ($T_1$).

4. Procédé selon l'une des revendications précédentes, comprenant en outre une étape de correction du déphasage entre le premier composant électronique (CE1) et le deuxième composant électronique (CE2), en fonction du déphasage déterminé à l'étape S60).

5. Procédé selon l'une des revendications précédentes, dans lequel la détermination du déphasage est effectuée de façon périodique.

6. Procédé selon l'une des revendications précédentes, dans lequel le premier signal d'étalonnage (S12) est routé sur une première ligne (L1), le deuxième signal d'étalonnage (S21) est routé sur une deuxième ligne (L2), la longueur de la première ligne (L1) et la longueur de la deuxième ligne (L2) étant égales.

7. Procédé selon l'une des revendications 1 à 5, dans lequel le premier signal d'étalonnage (S12) et le deuxième signal d'étalonnage (S21) sont routés sur une seule et même ligne bidirectionnelle, le deuxième signal d'étalonnage (S21) étant retardé par rapport à la réception du premier signal d'étalonnage (S12) de façon à éviter un conflit entre le premier signal d'étalonnage (S12) et le deuxième signal d'étalonnage (S21).

8. Système de détermination du déphasage entre un premier signal d'horloge (CK1) reçu par un premier composant électronique (CE1) et un deuxième signal d'horloge (CK2) reçu par un deuxième composant électronique (CE2), le premier signal d'horloge (CK1) et le deuxième signal d'horloge (CK2) étant générés de façon synchrone et ayant une période d'horloge identique ($T_c$), le système étant configuré pour :

- émettre un premier signal d'étalonnage (S12) par le premier composant électronique (CE1) de manière synchrone avec le premier signal d'horloge (CK1) ;

- mesurer un premier délai ($T_1$) entre un front actif du premier signal d'étalonnage (S12) et un front actif du deuxième signal d'horloge (CK2) consécutif au front actif du premier signal d'étalonnage (S12) ;

- émettre un deuxième signal d'étalonnage (S21) par le deuxième composant électronique (CE2) de manière synchrone avec le deuxième signal d'horloge (CK2) ;

- mesurer un deuxième délai ($T_2$) entre un front actif du deuxième signal d'étalonnage (S21) et un front actif du premier signal d'horloge (CK1) consécutif au front actif du deuxième signal d'étalonnage (S21) ;

- mesurer un nombre ($n$) de coups d'horloge entre le premier délai ($T_1$) et le deuxième délai ($T_2$), le nombre ($n$) de coups d'horloge correspondant à un multiple de la période d'horloge ($T_c$) ;
- déterminer un déphasage en fonction de la parité du nombre ($n$) de coups d'horloge, du premier délai ($T_1$) et du deuxième délai ($T_2$).

**9.** Système selon la revendication 8, dans lequel :

$$T_\phi = \frac{T_1 - T_2}{2} - \frac{T_c}{2}$$

si n est impair

$$T_\phi = \frac{T_1 - T_2}{2}$$

si n est pair Où $n$ correspond au nombre de coups d'horloge, $T_\phi$ correspond au déphasage entre le premier signal d'horloge (CK1) et le deuxième signal d'horloge (CK2), $T_1$ correspond au premier délai, $T_2$ correspond au deuxième délai, et $T_c$ correspond à la période d'horloge.

**10.** Système selon l'une des revendications 8 ou 9, dans lequel le premier composant électronique (CE1) et le deuxième composant électronique (CE2) sont des convertisseurs analogiques/numériques ou des convertisseurs numériques/analogiques.

**11.** Système d'antennes en réseau, **caractérisé en ce qu'**il comprend au moins un système de détermination du déphasage selon l'une des revendications 8 à 10.

**Patentansprüche**

**1.** Verfahren zum Bestimmen der Phasenverschiebung zwischen einem ersten von einem ersten elektronischen Bauelement (CE1) empfangenen ersten Taktsignal (CK1) und einem von einem zweiten elektronischen Bauelement (CE2) empfangenen zweiten Taktsignal (CK2), wobei das erste Taktsignal (CK1) und das zweite Taktsignal (CK2) synchron erzeugt werden und eine identische Taktperiode ($T_c$) aufweisen, die Schritte umfassend, bestehend aus:

S10) Senden eines ersten Kalibriersignals (S12) durch das erste elektronische Bauelement (CE1) synchron mit dem ersten Taktsignal (CK1);
S20) Messen einer ersten Verzögerung ($T_1$) zwischen einer aktiven Flanke des ersten Kalibriersignals (S12) und einer aktiven Flanke des zweiten Taktsignals (CK2) nach der aktiven Flanke des ersten Kalibriersignals (S12);
S30) Senden eines zweiten Kalibriersignals (S21) durch das zweite elektronische Bauelement (CE2) synchron mit dem zweiten Taktsignal (CK2);
S40) Messen einer zweiten Verzögerung ($T_2$) zwischen einer aktiven Flanke des zweiten Kalibriersignals (S21) und einer aktiven Flanke des ersten Taktsignals (CK1) nach der aktiven Flanke des zweiten Kalibriersignals (S21);
S50) Messen der Anzahl (n) an Taktschlägen zwischen dem Senden des ersten Kalibriersignals (S12) und der aktiven Flanke des ersten Taktsignals (CK1) nach der aktiven Flanke des zweiten Kalibriersignals (S21), wobei die Anzahl (n) an Taktschlägen einem Vielfachen der Taktperiode ($T_c$) entspricht;
S60) Bestimmen der Phasenverschiebung je nach Parität der Anzahl $(n)$ an Taktschlägen, der ersten Verzögerung ($T_1$) und der zweiten Verzögerung ($T_2$).

**2.** Verfahren nach Anspruch 1, wobei:

$$T_\phi = \frac{T_1 - T_2}{2} - \frac{T_c}{2}$$

wenn n ungerade ist

$$T_\phi = \frac{T_1 - T_2}{2}$$

wenn n gerade ist wobei n der Anzahl an Taktschlägen entspricht, $T_\phi$ der Phasenverschiebung zwischen dem ersten Taktsignal (CK1) und dem zweiten Taktsignal (CK2) entspricht, $T_1$ der ersten Verzögerung entspricht, $T_2$ der zweiten Verzögerung entspricht, und $T_c$ der Taktperiode entspricht.

3. Verfahren nach einem der vorstehenden Ansprüche, wobei das zweite Kalibriersignal (S21) nach einer vorbestimmten Anzahl an Taktschlägen nach der ersten Verzögerung ($T_1$) gesendet wird.

4. Verfahren nach einem der vorstehenden Ansprüche, weiter umfassend einen Schritt zum Korrigieren der Phasenverschiebung zwischen dem ersten elektronischen Bauelement (CE1) und dem zweiten elektronischen Bauelement (CE2), je nach der im Schritt S60) bestimmten Phasenverschiebung.

5. Verfahren nach einem der vorstehenden Ansprüche, wobei das Bestimmen der Phasenverschiebung periodisch durchgeführt wird.

6. Verfahren nach einem der vorstehenden Ansprüche, wobei das erste Kalibriersignal (S12) auf einer ersten Leitung (L1) geführt wird, das zweite Kalibriersignal (S21) auf einer zweiten Leitung (L2) geführt wird, wobei die Länge der ersten Leitung (L1) und die Länge der zweiten Leitung (L2) gleich sind.

7. Verfahren nach einem der Ansprüche 1 bis 5, wobei das erste Kalibriersignal (S12) und das zweite Kalibriersignal (S21) auf einer einzigen und gleichen bidirektionalen Leitung geführt werden, das zweite Kalibriersignal (S21) in Bezug auf den Empfang des ersten Kalibriersignals (S12) verzögert ist, um einen Konflikt zwischen dem ersten Kalibriersignal (S12) und dem zweiten Kalibriersignal (S21) zu vermeiden.

8. System zum Bestimmen der Phasenverschiebung zwischen einem ersten von einem ersten elektronischen Bauelement (CE1) empfangenen ersten Taktsignal (CK1) und einem von einem zweiten elektronischen Bauelement (CE2) empfangenen zweiten Taktsignal (CK2), wobei das erste Taktsignal (CK1) und das zweite Taktsignal (CK2) synchron erzeugt werden und eine identische Taktperiode ($T_c$) aufweisen, wobei das System konfiguriert ist, um:

- ein erstes Kalibriersignal (S12) durch das erste elektronische Bauelement (CE1) synchron mit dem ersten Taktsignal (CK1) zusenden;
- eine erste Verzögerung ($T_1$) zwischen einer aktiven Flanke des ersten Kalibriersignals (S12) und einer aktiven Flanke des zweiten Taktsignals (CK2) nach der aktiven Flanke des ersten Kalibriersignals (S12) zu messen;
- ein zweites Kalibriersignal (S21) durch das zweite elektronische Bauelement (CE2) synchron mit dem zweiten Taktsignal (CK2) zu senden;
- eine zweite Verzögerung ($T_2$) zwischen einer aktiven Flanke des zweiten Kalibriersignals (S21) und einer aktiven Flanke des ersten Taktsignals (CK1) nach der aktiven Flanke des zweiten Kalibriersignals (S21) zu messen;
- eine Anzahl *(n)* an Taktschlägen zwischen der ersten Verzögerung ($T_1$) und der zweiten Verzögerung ($T_2$) zu messen, wobei die Anzahl *(n)* an Taktschlägen einem Vielfachen der Taktperiode ($T_c$) entspricht;
- die Phasenverschiebung je nach Parität der Anzahl *(n)* an Taktschlägen, der ersten Verzögerung ($T_1$) und der zweiten Verzögerung ($T_2$) zu bestimmen.

9. System nach Anspruch 8 wobei:

$$T_\phi = \frac{T_1 - T_2}{2} - \frac{T_c}{2}$$

wenn n ungerade ist

$$T_\phi = \frac{T_1 - T_2}{2}$$

wenn n gerade ist wobei n der Anzahl an Taktschlägen entspricht, $T_\phi$ der Phasenverschiebung zwischen dem ersten Taktsignal (CK1) und dem zweiten Taktsignal (CK2) entspricht, $T_1$ der ersten Verzögerung entspricht, $T_2$ der zweiten

Verzögerung entspricht, und $T_c$ der Taktperiode entspricht.

10. System nach einem der Ansprüche 8 oder 9, wobei das erste elektronische Bauelement (CE1) und das zweite elektronische Bauelement (CE2) Analog-/DigitalWandler oder Digital-/Analog-Wandler sind.

11. Netzwerkantennensystem, **dadurch gekennzeichnet, dass** es mindestens ein System zum Bestimmen der Phasenverschiebung nach einem der Ansprüche 8 bis 10 umfasst.

**Claims**

1. Method for determining the phase difference between a first clock signal (CK1) received by a first electronic component (CE1) and a second clock signal (CK2) received by a second electronic component (CE2), the first clock signal (CK1) and the second clock signal (CK2) being generated synchronously and having an identical clock period ($T_c$), comprising the steps of:

   S10) transmitting by means of the first electronic component (CE1) a first calibration signal (512) synchronously with the first clock signal (CK1);
   S20) measuring a first delay ($T_1$) between an active edge of the first calibration signal (512) and an active edge of the second clock signal (CK2) consecutive to the active edge of the first calibration signal (S12);
   S30) transmitting by means of the second electronic component (CE2) a second calibration signal (S21) synchronously with the second clock signal (CK2);
   S40) measuring a second delay ($T_2$) between an active edge of the second calibration signal (S21) and an active edge of the first clock signal (CK1) consecutive to the active edge of the second calibration signal (S21);
   S50) measuring the number (n) of clock pulses between the transmission of the first calibration signal (S12) and the active edge of the first clock signal (CK1) consecutive to the active edge of the second calibration signal (S21), the number (n) of clock pulses corresponding to a multiple of the clock period ($T_c$);
   S60) determining the phase difference depending on the parity of the number (n) of clock pulses, of the first delay ($T_1$), and of the second delay ($T_2$).

2. Method according to Claim 1, wherein:

$$T_\phi = \frac{T_1 - T_2}{2} - \frac{T_c}{2}$$

if *n* is odd

$$T_\phi = \frac{T_1 - T_2}{2}$$

if *n* is even
where *n* corresponds to the number of clock pulses, $T_\phi$ corresponds to the phase difference between the first clock signal (CK1) and the second clock signal (CK2), $T_1$ corresponds to the first delay, $T_2$ corresponds to the second delay, and $T_c$ corresponds to the clock period.

3. Method according to one of the preceding claims, wherein the second calibration signal (S21) is transmitted after a predetermined number of clock pulses consecutive to the first delay ($T_1$).

4. Method according to one of the preceding claims, further comprising a step of correcting the phase difference between the first electronic component (CE1) and the second electronic component (CE2), depending on the phase difference determined in step S60).

5. Method according to one of the preceding claims, wherein the phase difference is determined periodically.

6. Method according to one of the preceding claims, wherein the first calibration signal (512) is routed over a first line (L1), the second calibration signal (S21) is routed over a second line (L2), the length of the first line (L1) and the length of the second line (L2) being equal.

7.  Method according to one of Claims 1 to 5, wherein the first calibration signal (512) and the second calibration signal (S21) are routed over the same bidirectional line, the second calibration signal (S21) being delayed with respect to receipt of the first calibration signal (512) so as to avoid a conflict between the first calibration signal (S12) and the second calibration signal (S21).

8.  System for determining the phase difference between a first clock signal (CK1) received by a first electronic component (CE1) and a second clock signal (CK2) received by a second electronic component (CE2), the first clock signal (CK1) and the second clock signal (CK2) being generated synchronously and having an identical clock period ($T_c$), the system being configured to:

    - transmit by means of the first electronic component (CE1) a first calibration signal (S12) synchronously with the first clock signal (CK1);
    - measure a first delay ($T_1$) between an active edge of the first calibration signal (512) and an active edge of the second clock signal (CK2) consecutive to the active edge of the first calibration signal (S12);
    - transmit by means of the second electronic component (CE2) a second calibration signal (S21) synchronously with the second clock signal (CK2);
    - measure a second delay ($T_2$) between an active edge of the second calibration signal (S21) and an active edge of the first clock signal (CK1) consecutive to the active edge of the second calibration signal (S21);
    - measure a number (n) of clock pulses between the first delay ($T_1$) and the second delay ($T_2$), the number (n) of clock pulses corresponding to a multiple of the clock period ($T_c$);
    - determine a phase difference depending on the parity of the number (n) of clock pulses, of the first delay ($T_1$), and of the second delay ($T_2$).

9.  System according to Claim 8, wherein:

$$T_\phi = \frac{T_1 - T_2}{2} - \frac{T_c}{2}$$

    if *n* is odd

$$T_\phi = \frac{T_1 - T_2}{2}$$

    if *n* is even
    where *n* corresponds to the number of clock pulses, $T_\phi$ corresponds to the phase difference between the first clock signal (CK1) and the second clock signal (CK2), $T_1$ corresponds to the first delay, $T_2$ corresponds to the second delay, and $T_c$ corresponds to the clock period.

10. System according to either of Claims 8 and 9, wherein the first electronic component (CE1) and the second electronic component (CE2) are analogue-to-digital converters or digital-to-analogue converters.

11. Array antenna system, **characterized in that** it comprises at least one system for determining phase difference according to one of Claims 8 to 10.

Fig. 1

Fig. 2

Fig. 3

Fig. 4

Fig. 5

Fig. 6

Fig. 7

Fig. 8

Fig. 9

**RÉFÉRENCES CITÉES DANS LA DESCRIPTION**

**Documents brevets cités dans la description**

- WO 2021032767 A1

- US 10509104 B1